Europäisches Patentamt

European Patent Office

Office européen des brevets

(11) Numéro de publication : **0 312 445 B1**

(12) # FASCICULE DE BREVET EUROPEEN

(45) Date de publication du fascicule du brevet :
**06.05.92 Bulletin 92/19**

(51) Int. Cl.$^5$ : **H03F 1/16, H03F 1/14**

(21) Numéro de dépôt : **88402567.7**

(22) Date de dépôt : **11.10.88**

(54) Amplificateur haute fréquence avec circuit de neutrodynage automatique.

Priorité : **16.10.87 FR 8714293**

(43) Date de publication de la demande :
**19.04.89 Bulletin 89/16**

(45) Mention de la délivrance du brevet :
**06.05.92 Bulletin 92/19**

(84) Etats contractants désignés :
**DE ES FR GB IT NL**

(56) Documents cités :
**FR-A- 892 018
US-A- 1 646 027
JAPANESE JOURNAL OF APPLIED PHYSICS,
vol. 20, Supplément 20-1, 1981 Proceedings of
the 12th Conference on Solid StateDevices,
1980, Tokyo, pages 87-91, Tokyo, JP; M. AIGA
et al.: "Gain improvement by self-neutralization of microwave SIT"**

(73) Titulaire : **THOMSON-CSF
51, Esplanade du Général de Gaulle
F-92800 Puteaux (FR)**

(72) Inventeur : **Benoit, Michel
THOMSON-CSF SCPI 19, avenue de Messine
F-75008 Paris (FR)**
Inventeur : **Peillex-Delphe, Guy
THOMSON-CSF SCPI 19, avenue de Messine
F-75008 Paris (FR)**

(74) Mandataire : **Guérin, Michel et al
THOMSON-CSF SCPI
F-92045 PARIS LA DEFENSE CEDEX 67 (FR)**

EP 0 312 445 B1

Jouve, 18, rue Saint-Denis, 75001 PARIS

## Description

La présente invention concerne les amplificateurs électroniques fonctionnant à haute fréquence. Par haute fréquence on entend ici des fréquences en principe supérieures à un mégahertz, mais plus généralement des fréquences suffisamment élevées, compte-tenu des réactances parasites des composants actifs utilisés dans l'amplificateur, pour qu' apparaissent des risques d'auto-oscillation de l'amplificateur.

Un risque d'auto-oscillation apparaît dès lors que les réactances parasites entraînent une réinjection, vers l'entrée de l'amplificateur, d'une fraction trop importante du signal de sortie, et dès lors que cette fraction vient s'ajouter au signal d'entrée d'origine.

L'invention est particulièrement applicable à des amplificateurs dont le composant actif principal est un tube électronique à vide (tube à grille tel qu'une triode, une tétrode, une pentode, etc.) et elle sera décrite en détail en se référant à ce type d'amplificateur. Mais elle est applicable plus généralement à d'autres types d'amplificateur, y compris des amplificateurs à transistors.

Les risques d'auto-oscillation d'un amplificateur à triode, dans un montage où la cathode de la triode est à la masse, sont dus essentiellement à l'existence d'une capacité parasite entre la grille de commande et l'anode de la triode. De la même manière, des risques d'auto-oscillation indésirable apparaissent dans un amplificateur à transistor par suite des capacités parasites de jonction entre d'une part la base du transistor et d'autre part le collecteur et l'émetteur; de même, pour un transistor à effet de champ, par suite des capacités entre grille de commande et source et drain.

Dans ce qui suit, on ne décrira que des montages à tubes à grille, sans pour autant que cela doive être considéré comme limitatif, l'invention étant applicable dès lors que l'amplificateur comporte un composant actif ayant au moins trois électrodes dont une reçoit un signal d'entrée en haute fréquence à amplifier, une autre fournit un signal haute fréquence amplifié, et une dernière sert notamment à définir une référence de potentiel pour les deux autres, au moins en ce qui concerne les hautes fréquences.

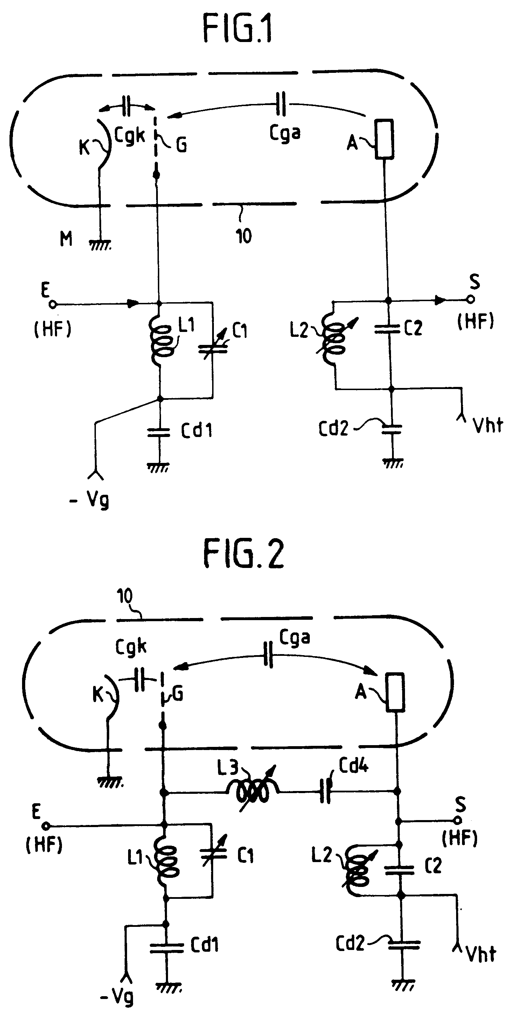

La figure 1 représente, à titre d'exemple, un amplificateur à triode dans lequel aucune précaution n'est prise pour neutraliser les risques d'auto-oscillation.

L'amplificateur comporte une triode 10 ayant une cathode K reliée à une masse M non seulement pour les courants alternatifs mais aussi pour le courant continu; une grille G reçoit le signal haute fréquence à amplifier, et une anode A fournit un signal haute fréquence amplifié. La grille G est connectée à une entrée E couplée à un étage précédent par des circuits de liaison et d'adaptation non représentés et dépendant de l'application envisagée. De même l'anode A est connectée à une sortie S reliée à un étage suivant par des circuits de liaison ou d'adaptation non représentés et dépendant de l'application envisagée. Par construction, étant donné la proximité des différentes électrodes les unes par rapport aux autres, il existe une capacité parasite Cgk entre grille et cathode, et une capacité parasite Cga entre grille et anode.

L'entrée de signal se fait par l'intermédiaire d'un circuit d'entrée accordable dans une gamme de fréquences à amplifier; dans l'exemple représenté, le circuit d'entrée accordé comporte une inductance L1 en parallèle avec une capacité C1; la valeur de l'inductance ou celle de la capacité est réglable pour régler l'amplificateur en fonction de la fréquence à amplifier. Ce circuit L1, C1, est connecté entre la grille et la masse par l'intermédiaire d'une capacité de découplage Cd1 dont la valeur est suffisamment élevée pour que son impédance soit négligeable devant celle des autres éléments de circuit aux fréquences considérées; ainsi le circuit L1, C1 peut être considéré comme ayant une borne virtuellement à la masse pour les courants à haute fréquence; une tension de polarisation négative -Vg est amenée à la grille G au travers de l'inductance L1.

Un autre circuit d'accord, comprenant une inductance L2 en parallèle avec une capacité C2, est connecté d'une part à l'anode A et d'autre part, à travers une capacité de découplage Cd2 ayant le même rôle que la capacité Cd1, à la masse M. L'inductance L2 ou la capacité C2 est réglable pour réaliser l'accord de fréquence à la sortie de l'amplificateur. Une haute tension d'alimentation Vht est appliquée à l'anode à travers l'inductance L2.

Le circuit ainsi décrit ne constitue qu'un exemple de réalisation. D'autres montages fréquemment utilisés comportent une arrivée de signal sur la cathode et non sur la grille, la grille étant mise à la masse pour le courant haute fréquence par une capacité de découplage analogue à la capacité Cd1. Certains montages utilisent même une entrée de signal sur la grille et une sortie sur la cathode, l'anode étant mise à la masse. Des circuits analogues pourraient être décrits, dans lesquels le composant actif est une tétrode ou une pentode.

Tous ces circuits sont sujets à des risques d'auto-oscillation dus aux capacités parasites entre sortie et entrée; la méthode la plus couramment utilisée pour neutraliser ce risque (méthode appelée opération de neutrodynage) consiste à placer en parallèle sur la capacité parasite gênante (la capacité Cga sur la figure 1 car elle ramène directement sur la grille une fraction du signal de sortie présent sur l'anode) des éléments de circuit inductifs tels que l'association de la capacité et de l'inductance en parallèle constitue un circuit "bouchon" à la fréquence de travail, c'est-à-dire un circuit d'impédance très grande, infinie dans le cas théorique où on néglige les pertes ohmiques. La fraction de signal réinjectée de la sortie (anode) vers l'entrée (grille) sera d'autant plus négligeable que cette impédance entre anode et grille sera élevée.

Cette méthode aboutit à un schéma comme par exemple celui de la figure 2. Sur cette figure, on voit qu'on a rajouté une inductance variable L3 en série avec une capacité Cd4, le tout en parallèle entre grille G et anode A. La capacité Cd4 est une capacité de liaison évitant la transmission de tension continue de l'anode à la grille; son inpédance est négligeable, aux fréquences considérée, devant celle de l'inductance L3. L'inductance L3 dont la valeur est telle que $L3.Cga.w^2 = 1$ constitue avec la capacité Cga un circuit bouchon d'impédance élevée, w étant la pulsation correspondant à la fréquence de travail; cette inductance réalise ainsi l'effet de neutrodynage recherché; l'inductance L3 est réalisée sous forme d'inductance variable pour permettre d'effectuer le réglage du neutrodynage à la mise en service de l'amplificateur à une fréquence de travail spécifiée par l'utilisateur ou pour pouvoir recommencer l'opération de neutrodynage à d'autres fréquences si l'utilisateur veut faire fonctionner son amplificateur à des fréquences différentes.

Un autre exemple de circuit est décrit dans le brevet US 1 646 027 avec un montage d'impédances en étoile.

L'utilisateur de l'amplificatuere devra procéder à plusieurs réglages à la mise en service ou lors des changements de fréquence de travail, pour aboutir
- à un neutrodynage efficace,
- à un accord de fréquence sur le circuit d'accord d'entrée L1, C1,
- à un accord de fréquence sur le circuit d'accord de sortie L2, C2,

Ces réglages multiples ont plusieurs inconvénients; le premier est naturellement le coût des éléments réglables (inductances variables, capacités variables) par rapport à des éléments fixes; le deuxième et le plus gênant est surtout le fait que chaque réglage réagit sur les autres: modifier la valeur de l'inductance L3, c'est modifier l'accord du circuit d'entrée et réciproquement.

Il est bien connu que le réglage de fréquence d'un amplificateur neutrodyné est une opération délicate qui se fait par approximations successives et que seuls des spécialistes peuvent faire rapidement. Lors de l'installation d'un amplificateur d'émission radioélectrique par exemple, l'installateur effectue cette opération; si un déréglage se produit ultérieurement, la reprise des réglages par l'utilisateur est très souvent approximative et se traduit soit par des pertes de performances soit par des incidents répétés nécessitant l'intervention de l'installateur, soit même par la destruction des composants et notamment du tube à grille.

Un but de l'invention est de proposer un montage amplificateur en haute fréquence quine présente pas ces inconvénients.

Pour y parvenir, on propose une structure de circuit avec trois impédances réactives connectées selon un montage en étoile entre les trois électrodes du tube ou plus généralement du composant actif, l'une des impédances réactives, connectée à une première électrode, étant réglable, et les deux autres impédances, connectées aux deux autres électrodes, étant fixes et essentiellement entre elles dans un rapport constant indépendant de la fréquence dans une plage de fréquences dans laquelle on désire faire fonctionner l'amplificateur.

On montrera que par un choix approprié du rapport entre les deux impédances fixes on peut obtenir un réglage rigoureusement simultané de l'accord d'entrée (ou l'accord de sortie selon les cas) et du neutrodynage dans toute la gamme de fréquences de l'amplificateur. Ce réglage se fait par variation de l'impédance réglable.

On définira ci-après une valeur théorique préférée pour ce rapport de deux impédances. Toutefois, dans la pratique, bien entendu on ne choisira peut-être pas exactement la valeur théorique optimale du rapport (d'autant plus qu'elle est difficilement mesurable), mais on se placera dans des conditions telles que le réglage du neutrodynage et de l'accord d'entrée ou de sortie puisse se faire simultanément à l'aide d'un seul élément de réglage.

En principe on s'arrangera pour que le rapport entre la réactance reliée à une deuxième électrode et la réactance reliée à une troisième électrode soit essentiellement égal au rapport entre d'une part la capacité existant entre la première électrode et la troisième et d'autre part la capacité existant entre la première électrode et la deuxième.

Une définition précise de l'invention est donnée dans les revendications indépendantes 1 et 5.

Dans certains modes de réalisation, la réactance variable sera une inductance variable permettant le réglage de fréquence par l'utilisateur et les deux autres réactances seront des capacités essentiellement fixes.

Dans d'autres réalisations, la réactance variable sera une inductance variable permettant le réglage de fréquence par l'utilisateur, et les deux autres réactances seront des inductances essentiellement fixes.

Dans d'autres réalisations encore, la réactance variable sera une capacité variable permettant le réglage de fréquence par l'utilisateur, et les deux autres réactances seront des inductances essentiellement fixes.

Dans le cas où l'élément de réglage doit servir à la fois au neutrodynage et au réglage de l'accord d'entrée, on considèrera que la première électrode est l'électrode recevant le signal d'entrée à amplifier, par exemple la grille d'une triode dans un montage cathode à la masse, la deuxième électrode étant l'électrode fournissant un signal de sortie amplifié (par exemple l'anode), et la trosième étant une électrode qui peut être portée à un potentiel de référence pour le signal à amplifier (par exemple la cathode).

La valeur préférentielle du rapport entre les réactances fixes connectées à la deuxième et à la troisième électrode est alors une valeur Cgm/Cga, dans laquelle:

— Cgm est la capacité existant entre la première électrode, recevant le signal d'entrée à amplifier, et la et la troisième électrode qui constitue la référence de potentiel pour le signal à amplifier; cette capacité est due aussi bien aux capacités parasites qu'aux capacités qui ont pu être volontairement rajoutées;

— Cga est la capacité présente entre la deuxième électrode, qui fournit un signal amplifié, et la première; elle résulte également aussi bien des capacités parasites que de capacités rajoutées volontairement.

Dans le cas où l'élément de réglage doit servir à la fois au réglage du neutrodynage et au réglage de l'accord de sortie, on considèrera que la première électrode est l'électrode fournissant le signal de sortie; la valeur préférentielle du rapport est C2/Cga où C2 est la capacité entre l'électrode de sortie (première électrode) et la troisième électrode, tandis que Cga est la capacité entre l'électrode de sortie (première électrode) et l'électrode d'entrée (deuxième électrode).

Dans tous les cas, surtout aux hautes fréquences, les impédances, y compris l'impédance réglable, peuvent être réalisées indifféremment par des éléments à constantes localisées telles que des condensateurs ou des bobinages, ou par des éléments à constantes réparties, c'est-à-dire des lignes, coaxiales ou bifilaires ouvertes ou court-circuitées, équivalentes selon le cas et en fonction de leur longueur à des réactances positives ou négatives c'est-à-dire à des inductances ou des capacités. L'impédance réglable est alors constituée par une telle ligne avec un court-circuit (ou un circuit ouvert) de position variable qui permet de faire varier la longueur effective de la ligne.

Enfin, et comme on l'a déjà dit, l'invention s'applique à des amplificateurs dont le composant actif principal peut-être constitué par d'autres éléments qu'une triode.

D'autres caractéristiques et avantages de l'invention apparaîtront à la lecture de la description détaillée qui suit et qui est faite en référence aux dessins annexés dans lesquels:

— la figure 1 et la figure 2 déjà décrites exposent le problème du neutrodynage et la solution pratique habituellement utilisée dans la technique antérieure;

— la figure 3 représente un schéma général de l'amplificateur neutrodyné selon l'invention, dans le cas où on veut faire en une seule opération le neutrodynage et l'accord de fréquence à l'entrée de l'amplificateur;

— la figure 4 explique l'équivalence mathématique entre une configuration de quadripôle en triangle et une configuration de quadripôle en étoile;

— la figure 5 représente un schéma d'amplificateur neutrodyné par un montage de trois réactances en triangle;

— la figure 6 représente un exemple de réalisation de l'invention dans lequel la réactance variable est une inductance;

— la figure 7 représente un autre exemple dans lequel la réactance variable est une capacité;

— la figure 8 représente un autre exemple avec une réactance variable inductive;

— la figure 9 représente un amplificateur neutrodyné par un montage de trois réactances en triangle;

— la figure 10 représente un schéma général d'amplificateur neutrodyné selon l'invention dans le cas où on veut faire en une seule opération le neutrodynage et l'accord de fréquence à la sortie de l'amplificateur.

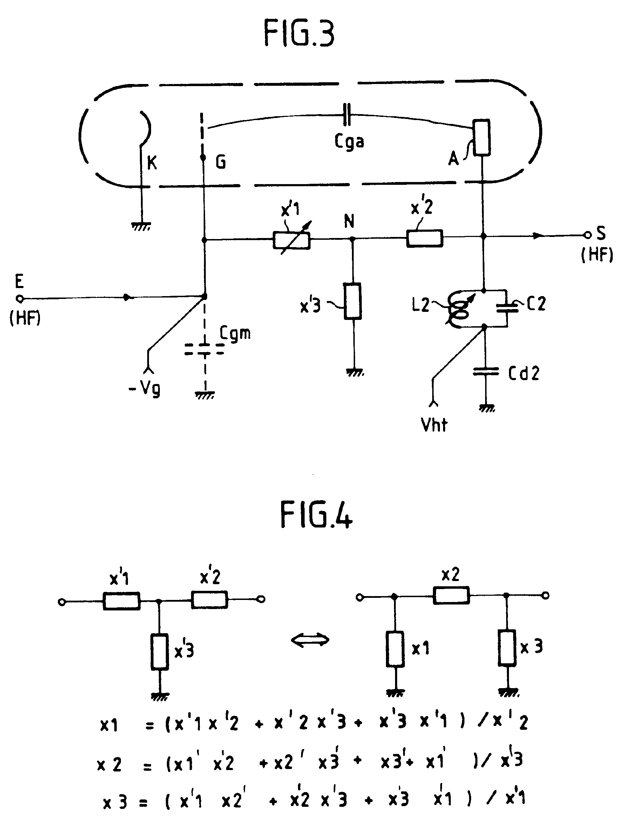

Un schéma général d'amplificateur neutrodyné selon l'invention apparaît à la figure 3 dans le cas d'un montage à triode avec cathode à la masse; on peut donc facilement exposer les différences essentielles de construction par rapport au schéma de la figure 2 qui est aussi un schéma de triode avec cathode à la masse.

L'inductance L1 des figures 1 et 2, qui servait à faire l'accord de fréquence à l'entrée de l'amplificateur, est supprimée. L'inductance L3, en série avec le condensateur de découplage Cd4 de la figure 2, est également supprimée et remplacée par un montage de trois réactances en étoile x'1, x'2, x'3, connectées entre les trois électrodes du tube, c'est-à-dire entre la grille G, la cathode K et l'anode A.

La réactance x'1, connectée entre l'électrode recevant le signal d'entrée, c'est-à-dire la grille G, et le noeud commun N du montage en étoile, est une réactance variable permettant à un utilisateur de régler la fréquence de fonctionnement de l'amplificateur.

Les réactances x'2 et x'3 sont des réactances fixes (ou tout au moins dont l'ajustement, effectué lors de l'installation, n'aura pas à être retouché lors d'un changement de fréquence de travail. Les valeurs des réactances x'2 et x'3 sont dans un rapport constant (indépendant de la fréquence) tel que lorsqu'on fait varier x'1 pour ajuster le fonctionnement de l'amplificateur à une fréquence choisie, l'accord d'entrée et le neutrodynage se fassent simultanément, et ceci d'une manière qui dépend peu du fait que l'accord de sortie a été préalablement réglé ou non. On explicitera plus loin la valeur préférentielle qu'il faut donner à ce rapport.

La réactance x'2 est connectée entre le noeud commun N et la deuxième électrode du tube, c'est-à-dire celle qui fournit le signal de sortie (ici l'anode A).

La réactance x'3 est connectée ente le noeud commun N du montage en étoile et la troisième électrode du tube (ici la cathode K qui est connectée à la masse).

On appelle Cgm la capacité présente entre la première électrode (grille G) et la troisième (cathode K à la masse M). Cette valeur Cgm comprend essentiellement la valeur de la capacité parasite grille-cathode Cgk dont on a parlé à propos des figures 1 et 2, mais aussi éventuellement des capacités supplémentaires rajoutées en parallèle entre grille et masse, comme par exemple la capacité C1 des figures 1 et 2. IL se trouve que le plus souvent, la capacité parasite Cgk est suffisamment forte pour qu'il n'y ait pas besoin de rajouter de capacité supplémentaire telle que C1 pour accorder l'amplificateur aux fréquences désirées.

On appelle Cga la capacité parasite entre première électrode (grille G) et deuxième (anode A).

Le rapport théorique préférentiel entre les réactances x'2 et x'3 est égal au rapport entre les capacités Cgm et Cga:

$$x'2/x'3 \ = \ Cgm/Cga$$

Voici maintenant une explication théorique permettant de justifier que le montage de la figure 3 permet, si on choisit convenablement les réactances x'2 et x'3, d'assurer un réglage simultané de l'accord d'entrée et du neutrodynage dans toute la gamme de fréquences de travail de l'amplificateur. Le réglage se fait par seule variation de la valeur de la troisième réactance.

Le montage en étoile des réactances x'1, x'2, x'3 est strictement équivalent d'un point de vue électrique à un montage en triangle de trois autres réactances x1, x2, x3 dont les valeurs sont liées à x'1, x'2, x'3 par les relations suivantes:

$$x1 \ = \ (x'1x'2 \ + \ x'2x'3 \ + \ x'3x'1)/x'2 \quad (1)$$
$$x2 \ = \ (x'1x'2 \ + \ x'2x'3 \ + \ x'3x'1)/x'3 \quad (2)$$
$$x3 \ = \ (x'1x'2 \ + \ x'2x'3 \ + \ x'3x'1)/x'1 \quad (3)$$

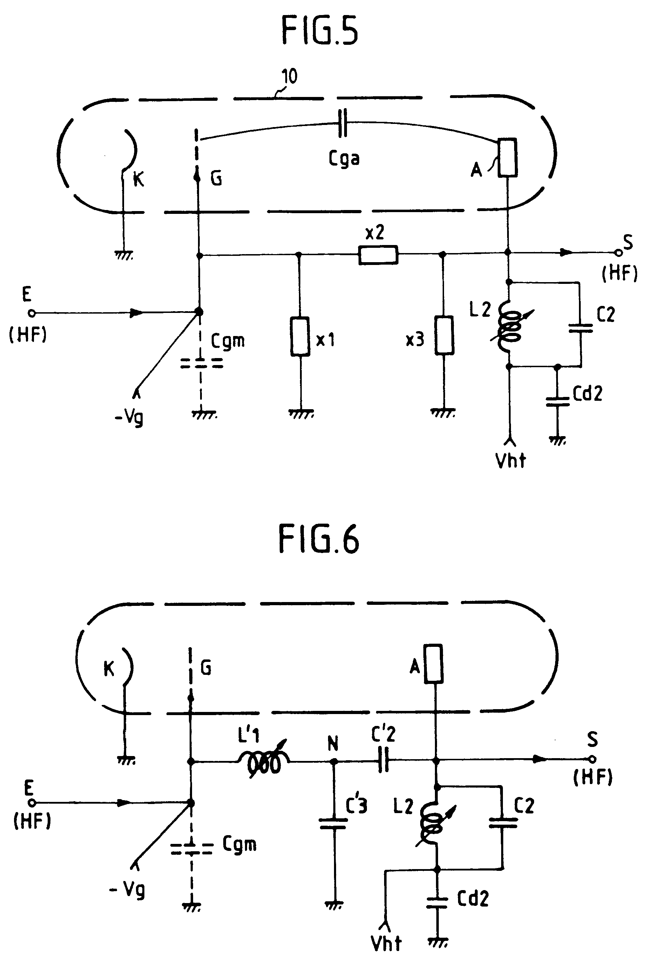

(voir la figure 4)

La figure 5 représente un schéma électrique théorique strictement équivalent au schéma de la figure 3 après transformation étoile/triangle. Le schéma de la figure 5 n'est pas utilisé dans la présente invention; il est donné pour faciliter l'explication des choix faits selon l'invention.

Le montage en triangle est proche de celui qui a été utilisé jusqu'à maintenant, comme par exemple à la figure 2: la réactance x1 serait l'inductance L1 qu'il faut mettre en parallèle sur la capacité Cgm pour faire un accord d'entrée par la formule $L1.Cgm.w^2 = 1$; la réactance x2 serait l'inductance L3 qu'il faut mettre en parallèle avec la capacité Cga pour faire le neutrodynage selon la formule $L3.Cga.w^2 = 1$; la réactance x3 serait considérée comme infinie dans le schéma de la figure 2, le circuit d'accord de sortie L2, C2 étant pris séparément et étant repris à la figure 3. Mais dans le montage de la figure 2, les inductances L2 et L3 doivent toutes deux être variables.

Dans la démarche de la présente invention on considère d'abord qu'on peut rajouter une réactance x3 non infinie en parallèle sur le circuit d'accord de sortie L2, C2, bien qu'une telle réactance ne paraisse pas nécessaire a priori, et qu'on peut ensuite transformer le montage en triangle des trois réactances x1, x2, x3 en un montage en étoile de trois réactances x'1, x'2, x'3, pour voir ce qu'il en résulte.

L'hypothèse de base, en partant du montage en triangle de la figure 5 est qu'on réalise à la fois un accord d'entrée et un neutrodynage efficace quelle que soit la fréquence si on peut écrire, quelle que soit la fréquence f (pulsation $w = 2¶f$), que la réactance x1 est une inductance pure égale à j/Cgm.w et que la réactance x2 est une inductance pure égale à j/Cga.w.

En effet, ces deux conditions expriment que le circuit x1, Cgm est un circuit bouchon accordé à la fréquence f et qu'il en est de même du circuit x2, Cga; les impédances de ces circuits accordés sont alors infinies.

Si ces égalités subsistent malgré les variations de la fréquence f, cela veut dire que l'impédance du circuit bouchon x1, Cgm restera infinie ainsi que l'impédance du circuit bouchon x2, Cga.

Par conséquent, si on se trouve dans ces conditions d'accord de fréquence pour les deux circuits bouchons simultanément, x3 pourra prendre n'importe quelle valeur sans modifier l'accord du circuit d'entrée ni du circuit de neutrodynage: quelle que soit la valeur de x3, l'impédance de x3 ne sera pas ramenée en parallèle sur x1 puisqu'elle en est isolée par l'impédance infinie du circuit accordé x2, Cga. De même, l'impédance de x3 ne sera pas ramenée en parallèle sur x2 puisqu'elle en est isolée par l'impédance infinie du circuit bouchon x1, Cgm.

Si on arrive par conséquent à maintenir en permanence les deux égalités indiquées ci-dessus :

$$x1 \ = \ j/Cgm.w \quad (4)$$

et

$$x2 \ = \ j/Cga.w \quad (5)$$

alors l'accord du circuit d'entrée et du neutrodynage pourra se faire en une seule opération, sans tâtonnements pour aboutir au résultat recherché par approximations successives.

La seule manière d'arriver simultanément aux deux égalités ci-dessus indépendamment de la fréquence est de maintenir le rapport x1/x2 constamment égal au rapport Cga/Cgm.

$$x1/x2 \ = \ Cga/Cgm \quad (6)$$

Les réactances x1 et x2 sont réalisées classiquement sous forme d'inductances variables, et il se trouve qu'on ne sait pas faire facilement deux inductances variant simultanément, au moyen d'un curseur de réglage unique, tout en restant dans le même rapport. C'est pourquoi la solution de neutrodynage classique utilise deux inductances variant indépendamment et des approximations successives pour parvenir à l'accord.

Selon l'invention, après avoir introduit conformément à la figure 5 la réactance supplémentaire x3 qui est apparemment inutile, on procède à la transformation triangle-étoile pour aboutir au schéma de la figure 3, et on réécrit les égalités ci-dessus en respectant les formules de transformation d'impédances rappelées à la figure 4.

Il en résulte d'abord que

$$x'3/x'2 = x1/x2 = Cga/Cgm \quad (7)$$

et ensuite que

$$x'1 = [(j/Cgm.w) - x'3]/[1 + (Cga/Cgm)] \quad (8)$$

L'équation (7) qui exprime la constance du rapport entre deux réactances est tout-à-fait analogue à l'équation (6). On pourrait donc penser que la transposition triangle-étoile n'a fait que reporter sur x'2 et x'3 le problème rencontré pour x1 et x2, c'est-à-dire la possibilité de faire varier deux réactances tout en les gardant constamment dans le même rapport.

La différence fondamentale avec le cas précédent se situe dans le fait que maintenant on peut choisir des réactances x'3 et x'2 constantes, dans le rapport Cga/Cgm, et faire varier x'1 en fonction de la fréquence f désirée de manière à maintenir l'égalité (8). Dans le cas de la figure 5 on ne peut pas garder x1 et x2 constants dans le rapport Cga/Cgm et faire varier x3 car la variation de x3 n'a alors aucune influence sur les accords recherchés.

Dans un premier mode de réalisation, représenté à la figure 6, on choisit une réactance capacitive pour x'2, et par conséquent aussi pour x'3. Une capacité C'2 est donc connectée entre la deuxième électrode (anode A) et le noeud commun N du montage en étoile; une capacité C'3 est connectée entre la troisième électrode (cathode K ou masse M) et le noeud commun.

Les capacités C'2 et C'3 sont dans le rapport :

$$C'3/C'2 = Cgm/Cga \quad (9)$$

pour que leurs réactances soient dans le rapport inverse.

Et la réactance x'1 doit prendre, en fonction de la formule (8) la valeur :

$$x'1 = [(j/Cgm.w) - 1/(jC'3.w)]/[1 + (Cga/Cgm)]$$

ou

$$x'1 = j[(1/Cgm.w) + (1/C'3.w)]/[1 + (Cga/Cgm)] \quad (10)$$

La réactance x'1 doit donc être une réactance positive et elle sera donc réalisée par une inductance variable dont la valeur variera entre deux limites qui seront choisies en fonction des valeurs numériques suivantes:

- valeur de la capacité parasite Cga et de la capacité Cgm;
- valeur choisie pour C'3;
- valeurs limites w0 et w1 de la plage de fréquences dans laquelle on veut pouvoir faire fonctionner l'amplificateur.

Lorsqu'on fera varier l'inductance entre ces limites, on trouvera une correspondance directe entre la valeur d'inductance et la valeur de fréquence pour laquelle l'accord de fréquence est réalisé. Un seul réglage sera nécessaire.

Lorsqu'on dit que les capacités C'3 et C'2 sont fixes, cela veut dire qu'elles ne sont pas destinées à être réglées par l'utilisateur lorsqu'il veut accorder son amplificateur (en particulier pour changer de fréquence de fonctionnement); mais on comprendra que l'une des deux capacités au moins peut être ajustable une fois pour toutes au moment de l'installation de l'amplificateur, (voire même en cas de remplacement du composant actif de l'amplificateur) compte-tenu des incertitudes qui pèsent sur la valeur des capacités Cga et Cgm.

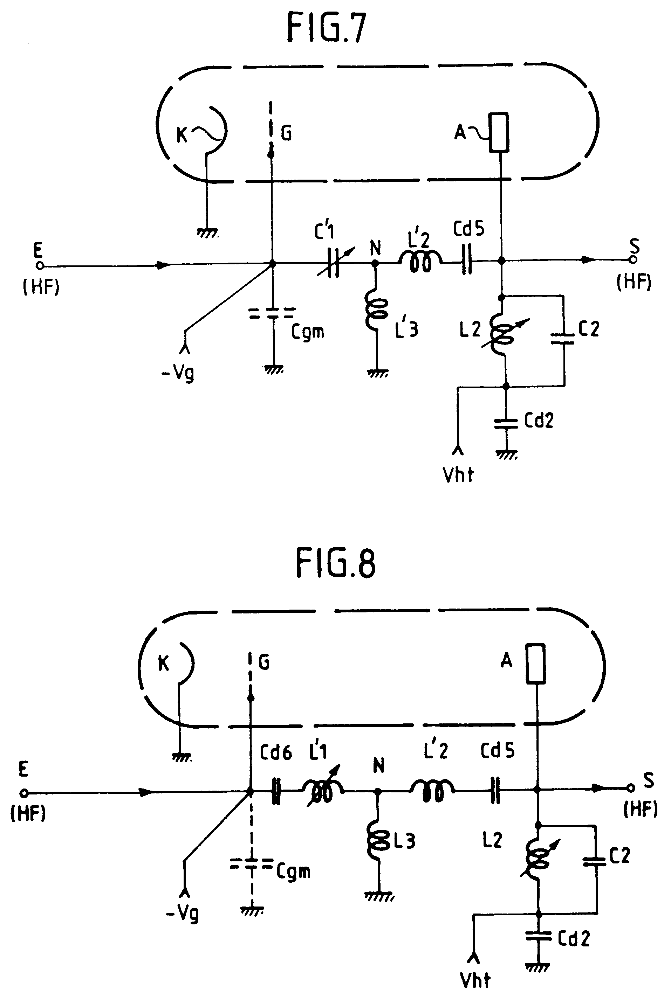

Dans une autre réalisation, visible à la figure 7, les réactances x'2 et x'3 sont réalisées sous forme d'inductances L'2 et L'3 et la réactance x'1 est réalisée sous forme d'une capacité variable C'1.

La valeur de la réactance x'1 se déduit de la formule (8), avec x'3 = jL'3.w

$$x'1 = [(j/Cgm.w) - jL'3.w)]/[1 + (Cga/Cgm)] \quad (11)$$

La valeur de l'inductance L'3 est choisie, en fonction de la plage de valeurs de fréquences désirée pour l'amplificateur, de telle sorte que L'3.w soit toujours nettement supérieur à 1/Cgm.w dans cette plage; ainsi, x'1 est une réactance négative dans toute cette plage et peut être réalisée sous forme d'une capacité variable C'1 comme cela est représenté à la figure 7.

Mais on voit à partir de la formule (11) que l'on peut aussi choisir une inductance L'3 telle que pour toute la plage de fréquences désirée, L'3.w soit inférieur à 1/Cgm.w. On réalise alors un montage tel que celui de la figure 8 car les trois réactances x'1, x'2, x'3 doivent maintenant être réalisées par trois inductances L'1, L'2, L'3, la première étant une inductance variable.

Enfin, on peut aussi choisir pour x'1 une impédance ayant à la fois une caractéristique inductive et une caractéristique capacitive, mais, bien entendu, pour ne pas perdre l'avantage essentiel de l'invention, c'est-à-dire la possibilité de réglage avec un seul élément variable, on n'utilisera pas à la fois une capacité variable et une inductance variable; on utilisera une ligne à constantes réparties qui, pour une fréquence donnée, aura une réactance soit positive soit négative selon sa longueur. L'accord de fréquence se fera par réglage de cette longueur.

Dans les figures 7 et 8, on a rajouté en série avec les inductances L'1 et L'2 des capacités de découplage Cd6 et Cd5 respectivement, pour éviter la transmission de potentiels continus entre l'anode et la grille par l'intermédiaire des inductances; ces capacités de découplage ont une valeur suffisamment élevée pour constituer des court-circuits d'impédance nulle aux fréquences de travail considérées; leur valeur n'intervient donc pas dans les formules mathématiques ci-dessus.

On va maintenant expliquer comment on peut transposer l'invention à des cas où on veut régler simultanément l'accord de sortie (et non plus l'accord d'entrée) et le neutrodynage; ceci peut-être intéressant par exemple dans le cas d'amplificateurs à large bande d'entrée dans lesquels pratiquement seule la sortie doit être accordée sur une fréquence de travail.

On repart du schéma de la figure 2 (schéma d'amplificateur classique neutrodyné, et on supprime d'une part l'inductance variable L2 d'accord de sortie et d'autre part l'inductance variable L3 de neutrodynage. Puis on interpose entre les électrodes de grille G, de cathode K, et d'anode A, un montage de trois réactances en triangle x1, x2, x3, comme à la figure 5: x1 entre grille et cathode, x2 entre grille et anode, x3 entre anode et cathode.

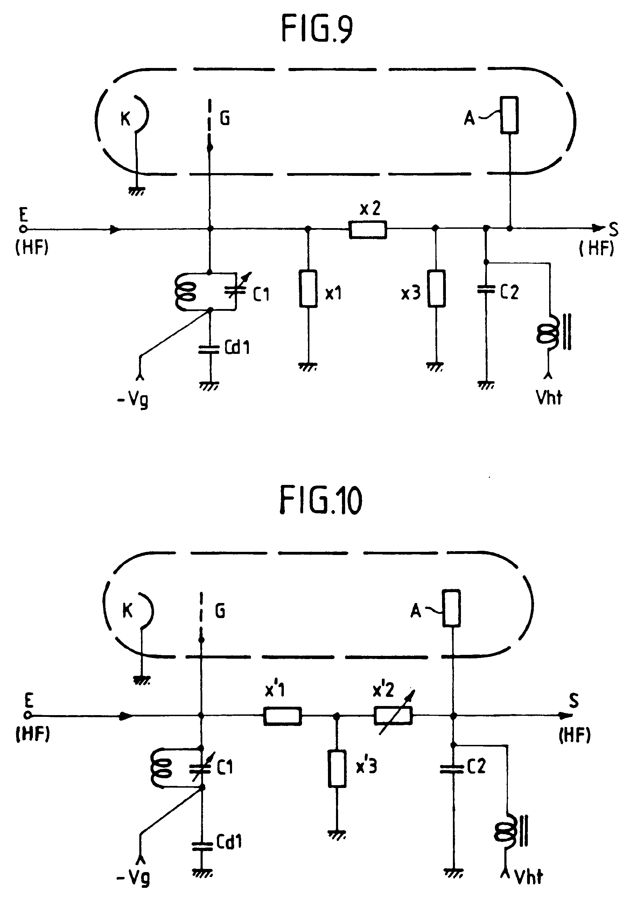

On aboutit au schéma de la figure 9, schéma qui n'est pas utilisé dans l'invention.

On transforme alors ce schéma en remplaçant les réactances x1, x2, x3 par un montage en étoile de trois réactances x′1, x′2, x′3, avec les mêmes relations mathématiques que précédemment; ces relations sont rappelées à la figure 4.

On aboutit au schéma de la figure 10.

Selon l'invention, on réalise les réactances x′1 et x′3 sous forme de réactances fixes (ou éventuellement ajustables une fois pour toutes en fonction des caractéristiques du tube et de la plage de fréquences désirée), et la réactance x′2 sous forme de réactance variable réglable par l'utilisateur en fonction de la fréquence de travail.

L'accord de sortie et le neutrodynage sont simultanément réalisés à condition qu'on ait simultanément:

$$x3 = j/C2.w \quad (12)$$

et

$$x2 = j/Cga.w \quad (13)$$

dans lequel C2 représente la capacité globale entre l'anode et la cathode. Ceci exprime qu'on a un circuit bouchon accordé en sortie et un circuit bouchon accordé entre anode et grille. Le raisonnement est le même que celui qui a été fait à propos de l'accord simultané d'entrée et de neutrodynage.

La seule manière d'arriver à ces deux égalités simultanément malgré les variations de fréquence est de maintenir le rapport x3/x2 constamment égal à Cga/C2.

En faisant la transformation triangle-étoile des impédances x1, x2, x3, ces deux égalités se réécrivent de la manière suivante:

$$x′3/x′1 = Cga/C2 \quad (14)$$

et

$$x′2 = [(j/C2.w) - x′3]/[1 + (Cga/C2)] \quad (15)$$

On peut très bien choisir les réactances x′1 et x′3 constantes et ajuster l'accord en agissant uniquement sur la valeur de la réactance x′2.

Comme pour l'accord d'entrée, plusieurs modes de réalisation sont possibles, parmi lesquels:

    a) x′1 et x′3 sont des capacités, et x′2 est alors une inductance variable;

    b) x′1 et x′3 sont des inductances (en série là où c'est nécessaire avec des capacités de découplage de réactance quasiment nulle), et x′2 est alors soit une inductance variable, soit une capacité variable en fonction du signe de (1/C2.w)-x′3 dans la gamme de fréquences considérée. Les impédances x′1, x′2 et x′3 peuvent naturellement aussi être des lignes à constantes réparties.

Sans entrer dans les détails de toutes les réalisations d'amplificateur possibles, on comprendra que l'invention est applicable chaque fois qu'un problème de neutrodynage et d'accord d'entrée ou de sortie doit être résolu.

Par exemple on peut utiliser l'invention dans le cas d'un montage de triode avec grille à la masse, le signal d'entrée étant appliqué sur la cathode et le signal de sortie étant fourni par l'anode.

Dans ce cas, la réactance x′1, variable si on effectue le neutrodynage simultanément avec l'accord d'entrée, est connectée entre le noeud commun du montage étoile et la cathode; la réactance x′2, variable si on veut effectuer le neutrodynage en même temps que l'accord de sortie, est connectée entre le noeud commun et la grille, et la réactance x′3, fixe, est connectée entre le noeud commun et la grille. Le calcul des réactances fait alors apparaître que le rapport de réactances x′2/x′3 (cas du neutrodynage avec accord d'entrée) est de préférence égal à Ckm/Cka, où Ckm est la capacité globale (capacité parasite et capacités extérieures éventuelles) existant entre cathode et grille, et Cka est la capacité globale (en principe une capacité parasite) entre anode et cathode. Le terme Cgm/Cga des équations (9) et (10) doit donc être remplacé par Ckm/Cka. Dans le cas du neutrodynage fait avec l'accord de sortie, la capacité Cga doit être remplacée par la capacité Cka dans les équations 14 et 15 pour obtenir les équations définissant les valeurs relatives des trois réactances en étoile.

D'autres montages sont encore possibles par exemple avec des tétrodes ou pentodes, et dans ce cas, le montage de trois réactances est effectué entre l'électrode recevant le signal d'entrée à amplifier, l'électrode fournissant le signal de sortie et l'électrode définissant la référence de potentiel (masse) pour ces deux signaux. Les autres électrodes modifient éventuellement la distribution des capacités parasites mais ne modifient pas le principe de l'invention.

## Revendications

1. Amplificateur haute fréquence pourvu d'au moins un composant actif, ce composant actif comportant au moins trois électrodes (G, K, A) et trois réactances (x'1, x'2, x'3) en étoile entre un noeud commun (N) et chacune des électrodes, caractérisé en ce que, en vue de faciliter l'accord sur la fréquence de travail et le neutrodynage de l'amplificateur, l'une des réactances (x'1), connectée à une première électrode d'entrée de signal à amplifier, est variable pour effectuer l'accord de fréquence à l'entrée de l'amplificateur et le neutrodynage, et les deux autres réactances (x'2 et x'3), connectées aux deux autres électrodes, sont fixes et essentiellement entre elles dans un rapport constant indépendant de la fréquence dans la plage de fréquences où on veut pouvoir faire fonctionner l'amplificateur, le rapport entre la réactance (x'2) reliée à une deuxième électrode et la réactance (x'3) reliée à une troisième électrode étant essentiellement égal au rapport entre d'une part la capacité (Cgm) existant entre la première électrode et la troisième et d'autre part la capacité (Cga) existant entre la première électrode et la deuxième

2. Amplificateur selon la revendication 1, caractérisé en ce que la réactance variable est une inductance variable (L'1) permettant le réglage de fréquence par l'utilisateur et en ce que les deux autres réactances sont des capacités essentiellement fixes (C'2, C'3), éventuellement ajustables une fois pour toutes en fonction des caractéristiques du composant actif et de la plage de fréquences de travail désirée.

3. Amplificateur selon la revendication 1, caractérisé en ce que la réactance variable est une inductance variable (L'1) permettant le réglage de fréquence par l'utilisateur, et en ce que les deux autres réactances sont des inductances essentiellement fixes (L'1, L'2), éventuellement ajustables une fois pour toutes en fonction des carastéristiques du composant actif et de la plage de fréquences de travail désirée.

4. Amplificateur selon la revendication 1, caractérisé en ce que la réactance variable est une capacité variable (C'1) permettant le réglage de fréquence par l'utilisateur, et en ce que les deux autres réactances sont des inductances essentiellement fixes (L'2, L'3), éventuellement ajustables une fois pour toutes en fonction des caractéristiques du composant actif et de la plage de fréquences désirée.

5. Amplificateur haute fréquence pourvu d'au moins un composant actif, ce composant actif comportant au moins trois électrodes (G, K, A) et trois réactances (x'1, x'2, x'3) en étoile entre un noeud commun (N) et chacune des électrodes, caractérisé en ce que, en vue de faciliter l'accord sur la fréquence de travail et le neutrodynage de l'amplificateur, l'une des réactances (x'1), connectée à une première électrode, est variable pour effectuer l'accord de fréquence à la première électrode et le neutrodynage, et les deux réactances (x'2 et x'3), connectées aux deux autres électrodes, sont fixes et essentiellement entre elles dans un rapport constant indépendant de la fréquence dans la plage de fréquences où on veut pouvoir faire fonctionner l'amplificateur, le rapport entre la réactance (x'2) reliée à une deuxième électrode et la réactance (x'3) reliée à une troisième électrode étant essentiellement égal au rapport entre d'une part la capacité (Cgm) existant entre la première électrode et la troisième et d'autre part la capacuté (Cga) existant entre la première électrode et la deuxième.

6. Amplificateur selon la revendication 5, caractérisé en ce que la réactance variable est une inductance variable (L'1) permettant le réglage de fréquence par l'utilisateur et en ce que les deux autres réactances sont des capacités essentiellement fixes (C'2, C'3), éventuellement ajustables urne fois pour toutes en fonction des caractéristiques du composant actif et de la plage de fréquences de travail désirée.

7. Amplificateur selon la revendication 5, caractérisé en ce que la réactance variable est une inductance variable (L'1) permettant le réglage de fréquence par l'utilisateur, et en ce que les deux autres réactances sont des inductances essentiellement fixes (L'1, L'2), éventuellement ajustables une fois pour toutes en fonction des caractéristiques du composant actif et de la plage de fréquences de travail désirée.

8. Amplificateur selon la revendication 5, caractérisé en ce que la réactance variable est une capacité variable (C'1) permettant le réglage de fréquence par l'utilisateur, et en ce que les deux autres réactances sont des inductances essentiellement fixes (L'2, L'3), éventuellement ajustables une fois pour toutes en fonction des caractéristiques du composant actif et de la plage de fréquences désirée.

9. Amplificateur selon l'une des revendications 5 à 8, caractérisé en ce que la première électrode est une électrode d'entrée de signal pour l'amplificateur, les deuxième et troisième électrodes étant respectivement des électrodes de sortie de signal et de référence de potentiel pour les signaux de haute fréquence.

10. Amplificateur selon l'une des revendications 5 à 8, caractérisé en ce que la première électrode est une électrode de sortie de signal pour l'amplificateur, les deuxième et troisième électrodes étant respectivement des électrodes d'entrée de signal et de référence de potentiel pour les signaux de haute fréquence.

11. Amplificateur selon l'une des revendications 1 à 10, caractérisé en ce que le composant actif est un tube à grille ayant au moins une grille, une anode, et une cathode qui constituent les trois électrodes mentionnées.

## Claims

1. A high frequency amplifier provided with a least one active component, said active component comprising at least three electrodes (G, K and A) and three reactances (x'1, x'2 and x'3) in a star circuit between a common connection (N) and a respective one of the electrodes characterized in that, for the purpose of facilitating matching with respect to the frequency of working and the oscillation prevention of the amplifier, one of the reactances (x'1), connected with a first electrode for the input of the signal to be amplified, is able to be varied in order to bring about frequency matching at the input of the amplifier and the oscillation prevention of, and the two other reactances (x'2 and x'3), connected with the two other electrodes, are fixed and essentially have a relationship between them which is constant and independent of the frequency in the range of the frequencies, wherein operation of the amplifier is desired, the relationship between the reactance (x'2) connected with a second electrode and the reactance (x'3) connected with a third electrode being essentially equal to the relationship between on the one hand the capacity (Cgm) existing between the first electrode and the third electrode and on the other hand the capacity (Cga) existing between the first electrode and the second electrode.

2. The amplifier as claimed in claim 1, characterized in that the variable reactance is a variable inductance (L'1) permitting the regulation of the frequency by the user and in that the two other reactances are essentially fixed capacitors (C'2 and C'3), which are if necessary adjustable a single time only as a function of the characteristics of the active component and of the range of the operational frequencies desired.

3. The amplifier as claimed in claim 1, characterized in that the variable reactance is a variable inductance (L'1) permitting the regulation of the frequency by the user and in that the two other reactances are essentially fixed inductances (L'1 and L'2), which are if necessary adjustable a single time only as a function of the characteristics of the active component and of the range of the operational frequencies desired.

4. The amplifier as claimed in claim 1, characterized in that the variable reactance is a variable capacitor (C'1) permitting the regulation of the frequency by the user and in that the two other reactances are essentially fixed inductances (L'2 and L'3), which are if necessary adjustable a single time only as a function of the characteristics of the active component and of the range of the operational frequencies desired.

5. A high frequency amplifier provided with at least one active component, said active component comprising at least three electrodes (G, K and A) and three reactances (x'1, x'2 and x'3) in a star circuit between a common connection (N) and a respective one of the electrodes, characterized in that, for the purpose of facilitating matching with respect to the frequency of working and the oscillation prevention, one of the reactances (x'1), connected with a first electrode, is able to be varied in order to bring about frequency matching at the first electrode and the oscillation prevention, and the two other reactances (x'2 and x'3), connected with the two other electrodes are fixed and essentially have a relationship between them which is constant and independent of the frequency in the range of the frequencies, wherein operation of the amplifier is desired, the relationship between the reactance (x'2) connected with a second electrode and the reactance (x'3) connected with a third electrode being essentially equal to the relationship between on the one hand the capacity (Cgm) existing between the first electrode and the third electrode and on the other hand the capacity (Cga) existing between the first electrode and the second electrode.

6. The amplifier as claimed in claim 5, characterized in that the variable reactance is a variable inductance (L'1) permitting the regulation of the frequency by the user and in that the two other reactances are essentially fixed capacitors (C'2 and C'3), which are if necessary adjustable a single time only as a function of the characteristics of the active component and of the range of the operational frequencies desired.

7. The amplifier as claimed in claim 5, characterized in that the variable reactance is a variable inductance (L'1) permitting the regulation of the frequency by the user and in that the two other reactances are essentially fixed inductances (L'1 and L'2), which are if necessary adjustable a single time only as function of the characteristics of the active component and of the range of the operational frequencies desired.

8. The amplifier as claimed in claim 5, characterized in that the variable reactance is a variable capacitor (C'1) permitting the regulation of the frequency by the user and in that the two other reactances are essentially fixed inductances (L'2 and L'3), which are if necessary adjustable a single time only as a function of the characteristics of the active component and of the range of the operational frequencies desired.

9. The amplifier as claimed in any one of claims 5 through 8, characterized in that the first electrode is an electrode for the input of the signal to the amplifier, the second and the third electrodes being respectively electrodes for signal ouput and for reference potential for the high frequency signal.

10. The amplifier as claimed in any one of claims 5 through 8, characterized in that the first electrode is an electrode for the output of the signal to the amplifier, the second and the third electrodes being respectively electrodes for signal input and for reference potential for the high frequency signals.

11. The amplifier as claimed in any one of claims 1 through 10, characterized in that the active component is a grid tube having at least one grid, an anode a cathode which constitue the three electrodes mentioned.

**Patentansprüche**

1. Hochfrequenzverstärker, der mit wenigstens einem aktiven Bauelement versehen ist, das wenigstens drei Elektroden (G, K, A) und drei zwischen einem gemeinsamen Knoten (N) und jeder der Elektroden sternförmig angeordnete Blindwiderstände ($x'1$, $x'2$, $x'3$) umfaßt, dadurch gekennzeichnet, daß im Hinblick auf eine Erleichterung der Abstimmung auf die Arbeitsfrequenz und die Schwingneigungsunterdrückung des Verstärkers derjenige der Blindwiderstände ($x'1$,), der mit einer ersten Eingangselektrode für das zu verstärkende Signal verbunden ist, variabel ist, um die Frequenzabstimmung am Eingang des Verstärkers und die Schwing- neigungsunterdrückung auszuführen, und die zwei anderen Blindwiderstände ($x'2$ und $x'3$), die mit den zwei anderen Elektroden verbunden sind, fest sind und im wesentlichen in einem konstanten Verhältnis zueinander stehen, das in einem Frequenzbereich, in dem der Verstärker betrieben werden soll, unabhängig von der Frequenz ist, wobei das Verhältnis zwischen dem mit einer zweiten Elektrode verbundenen Blindwiderstand ($x'2$) und dem mit einer dritten Elektrode verbundenen Blindwiderstand ($x'3$) im wesentlichen gleich dem Verhältnis ist zwischen einerseits der Kapazität (Cgm), die zwischen der ersten Elektrode und der dritten vorhanden ist, und andererseits der Kapazität (Cga), die zwischen der ersten Elektrode und der zweiten vorhanden ist.

2. Verstärker gemäß Anspruch 1, dadurch gekennzeichnet, daß der variable Blindwiderstand eine variable Induktivität ($L'1$) ist, die die Einstellung der Frequenz durch den Benutzer erlaubt, und daß die zwei anderen Blindwiderstände im wesentlichen feste Kapazitäten ($C'2$, $C'3$) sind, die eventuell einmal endgültig in Abhängigkeit von den Eigenschaften des aktiven Bauelementes und vom gewünschten Arbeitsfrequenzbereich einstellbar sind.

3. Verstärker gemäß Anspruch 1, dadurch gekennzeichnet, daß der variable Blindwiderstand eine variable Induktivität ($L'1$) ist, die die Einstellung der Frequenz durch den Benutzer erlaubt, und daß die zwei anderen Blindwiderstände im wesentlichen feste Induktivitäten ($L'1$, $L'2$) sind, die eventuell einmal endgültig in Abhängigkeit von den Eigenschaften des aktiven Bauelementes und vom gewünschten Arbeitsfrequenzbereich einstellbar sind.

4. Verstärker gemäß Anspruch 1, dadurch gekennzeichnet, daß der variable Blindwiderstand eine variable Kapazität ($C'1$) ist, die die Einstellung der Frequenz durch den Benutzer erlaubt, und daß die zwei anderen Blindwiderstände im wesentlichen feste Induktivitäten ($L'2$, $L'3$) sind, die eventuell einmal endgültig in Abhängigkeit von den Eigenschaften des aktiven Bauelementes und vom gewünschten Frequenzbereich einstellbar sind.

5. Hochfrequenzverstärker, der mit wenigstens einem aktiven Bauelement versehen ist, das wenigstens drei Elektroden (G, K, A) und drei zwischen einem gemeinsamen Knoten (N) und jeder der Elektroden sternförmig angeordnete Blindwiderstände ($x'1$, $x'2$, $x'3$) umfaßt, dadurch gekennzeichnet, daß im Hinblick auf eine Erleichterung der Abstimmung auf die Arbeitsfrequenz und die Schwingneigungsunterdrückung des Verstärkers derjenige der Blindwiderstände ($x'1$), der mit einer ersten Elektrode verbunden ist, variabel ist, um die Abstimmung der Frequenz bei der ersten Elektrode und die Schwingneigungsunterdrückung auszuführen, und daß die zwei anderen Blindwiderstände ($x'2$ und $x'3$), die mit den zwei anderen Elektroden verbunden sind, fest sind und zueinander im wesentlichen in einem konstanten Verhältnis stehen, das im Frequenzbereich, in dem der Verstärker arbeiten soll, von der Frequenz unabhängig ist, wobei das Verhältnis zwischen dem mit einer zweiten Elektrode verbundenen Blindwiderstand ($x'2$) und dem mit einer dritten Elektrode verbundenen Blindwiderstand ($x'3$) im wesentlichen gleich dem Verhältnis ist zwischen einerseits der Kapazität (Cgm), die zwischen der ersten Elektrode und der dritten vorhanden ist, und andererseits der Kapazität (Cga), die zwischen der ersten Elektrode und der zweiten vorhanden ist.

6. Verstärker gemäß Anspruch 5, dadurch gekennzeichnet, daß der variable Blindwiderstand eine variable Induktivität ($L'1$) ist, die die Einstellung der Frequenz durch den Benutzer erlaubt, und daß die zwei anderen Blindwiderstände im wesentlichen feste Kapazitäten ($C'2$, $C'3$) sind, die eventuell einmal endgültig in Abhängigkeit von den Eigenschaften des aktiven Bauelementes und vom gewünschten Arbeitsfrequenzbereich einstellbar sind.

7. Verstärker gemäß Anspruch 5, dadurch gekennzeichnet, daß der variable Blindwiderstand eine variable Induktivität ($L'1$) ist, die die Einstellung der Frequenz durch den Benutzer erlaubt, und daß die zwei anderen Blindwiderstände im wesentlichen feste Induktivitäten ($L'1$, $L'2$) sind, die eventuell einmal endgültig in Abhängigkeit von den Eigenschaften des aktiven Bauelementes und vom gewünschten Arbeitsfrequenzbereich einstellbar sind.

8. Verstärker gemäß Anspruch 5, dadurch gekennzeichnet, daß der variable Blindwiderstand eine variable Kapazität ($C'1$) ist, der die Einstellung der Frequenz durch den Benutzer erlaubt, und daß die zwei anderen Blindwiderstände im wesentlichen feste Induktivitäten ($L'2$, $L'3$) sind, die eventuell einmal endgültig in Abhängigkeit von den Eigenschaften des aktiven Bauelementes und vom gewünschten Frequenzbereich einstellbar sind.

9. Verstärker gemäß einem der Ansprüche 5 bis 8, dadurch gekennzeichnet, daß die erste Elektrode eine Signaleingangselektrode für den Verstärker ist, wobei die zweite und die dritte Elektrode eine Signalausgangselektrode bzw. eine Referenzpotentialelektrode für die Hochfrequenzsignale sind.

10. Verstärker gemäß einem der Ansprüche 5 bis 8, dadurch gekennzeichnet, daß die erste Elektrode eine Signalausgangselektrode für den Verstärker ist, wobei die zweite und die dritte Elektrode eine Signaleingangselektrode bzw. eine Referenzpotentialelektrode für die Hochfrequenzsignale sind.

11. Verstärker gemäß einem der Ansprüche gemäß 1 bis 10, dadurch gekennzeichnet, daß das aktive Bauelement eine Leistungsgitterröhre ist, die wenigstens ein Gitter, eine Anode und eine Kathode umfaßt, die die drei erwähnten Elektroden darstellen.

# FIG.1

# FIG.2

# FIG.3

# FIG.4

$$x1 = (x'1 \, x'2 + x'2 \, x'3 + x'3 \, x'1) / x'2$$

$$x2 = (x1' \, x'2 + x2' \, x'3 + x3' + x1') / x'3$$

$$x3 = (x'1 \, x2' + x'2 \, x'3 + x'3 \, x'1) / x'1$$

# FIG.5

# FIG.6

EP 0 312 445 B1

## FIG.7

## FIG.8

# FIG.9

# FIG.10